# EUROPÄISCHE PATENTANMELDUNG

(11) **EP 3 751 737 A1**
(43) Veröffentlichungstag der Anmeldung: **16.12.2020**
(21) Anmeldenummer: 20159641.8
(22) Anmeldetag: 26.02.2020
(51) Int. Cl.: H03K 17/0812, H03K 17/16, H03K 17/284

(54) **TÜRÖFFNER**

(30) Priorität: 13.06.2019 DE 102019208621
(71) Anmelder: GEZE GmbH, 71229 Leonberg (DE)
(72) Erfinder: Benchokroun, Adnane, 75179 Pforzheim (DE)

(57) **Zusammenfassung**

Ein Türöffner zum Entsperren einer Türfalle umfasst eine wenigstens einen Eingangskondensator (12) aufweisende integrierte Elektronik, die durch eine Stromversorgungseinrichtung (16) über eine zur Begrenzung des Einschaltstroms mit dem Eingangskondensator in Reihe schaltbare, insbesondere stromkompensierte Drossel (18) mit Strom versorgbar ist. Zur weiteren Begrenzung des Einschaltstroms ist eine Einschaltstrombegrenzungseinrichtung (20) mit einem mit dem Eingangskondensator in Reihe schaltbaren Halbleiterbauelement (22) mit variablem steuerbarem Durchgangswiderstand und einer Verzögerungsschaltung (24) vorgesehen, über die das Halbleiterbauelement mit variablem steuerbarem Durchgangswiderstand so ansteuerbar ist, dass dessen Durchgangswiderstand mit einem jeweiligen Einschalten der Stromversorgung zur Reduzierung der Aufladungsgeschwindigkeit des Eingangskondensators ausgehend von einem relativ höheren Wert mit einer vorgegebenen oder vorgebbaren Zeitkonstante zunehmend kleiner wird.

## Beschreibung

Die Erfindung betrifft einen Türöffner zum Entsperren einer Türfalle mit einer wenigstens einen Eingangskondensator umfassenden integrierten Elektronik, die durch eine Stromversorgungseinrichtung über eine zur Begrenzung des Einschaltstroms mit dem Eingangskondensator in Reihe schaltbare, insbesondere stromkompensierte Drosseln mit Strom versorgbar ist.

Bei einem Türöffner handelt es sich um eine elektrische, mit Fernbedienung im Türrahmen eingebaute Vorrichtung mit in der Regel elektromagnetischer Schlossfallen-Entriegelung. Die Falle des im Türblatt eingebauten Einsteckschlosses greift bei geschlossener Tür in die Falle des Türöffners. Bei durch einen Taster oder Relais der Fernbedienung erfolgender Kontaktgabe wird die Sperre der Falle des Türöffners aufgehoben, wonach die Tür geöffnet werden kann. Nach dem Schließen der Tür hält die erneut gesperrte Falle des Türöffners die Tür, d. h. die Falle des Einsteckschlosses, wieder fest.

Bei Türöffnern der eingangs genannten Art dient der Eingangskondensator der Herabsetzung elektromagnetischer Störungen (EMV, elektromagnetische Verträglichkeit). Die mit diesem in Reihe geschaltete stromkompensierte Drossel dient der Begrenzung des Einschaltstroms. Der Eingangskondensator kann beispielsweise einem Transformator, insbesondere einem Transformator mit zugeordnetem Gleichrichter, nachgeschaltet sein. In der Regel ist der Eingangskondensator auch mit dem als Schaltkontakt dienenden Taster bzw. Relais in Reihe geschaltet.

Eine stromkompensierte Drossel oder Gleichtaktdrossel (CMC, common mode choke) besitzt mehrere gleiche Wicklungen, die gegensinnig vom Arbeitsstrom durchflossen werden, so dass sich deren magnetische Felder im Kern der Drossel aufheben.

Trotz der stromkompensierten Drossel kann der Einschaltstrom infolge des Einschaltkondensators noch zu hoch sein. Dies ist insbesondere dann der Fall, wenn mit dem Eingangskondensator ein als Schaltkontakt dienendes Relais in Reihe geschaltet ist. Bei zu hohen Einschaltströmen besteht dann die Gefahr, dass ein solches Relais verklebt.

Der Erfindung liegt die Aufgabe zugrunde, einen Türöffner der eingangs genannten Art anzugeben, mit dem die zuvor erwähnten Probleme beseitigt sind. Dabei soll auf möglichst einfache und zuverlässige Weise insbesondere eine weitere Begrenzung des Einschaltstroms erreicht werden.

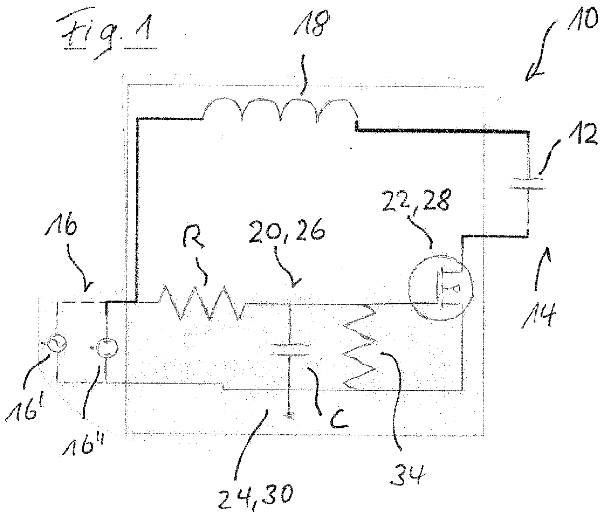

Erfindungsgemäß wird diese Aufgabe durch einen Türöffner mit den Merkmalen des Anspruchs 1 gelöst. Bevorzugte Ausführungsformen des erfindungsgemäßen Türöffners ergeben sich aus den Unteransprüchen, der vorliegenden Beschreibung sowie der Zeichnung.

Der erfindungsgemäße Türöffner umfasst eine wenigstens einen Eingangskondensator aufweisende integrierte Elektronik, die durch eine Stromversorgungseinrichtung über eine zur Begrenzung des Einschaltstroms mit dem Eingangskondensator in Reihe schaltbare, insbesondere stromkompensierte Drossel mit Strom versorgbar ist. Dabei ist zur weiteren Begrenzung des Einschaltstroms eine Einschaltstrombegrenzungseinrichtung mit einem mit dem Eingangskondensator in Reihe schaltbaren Halbleiterbauelement mit variablem steuerbarem Durchgangswiderstand und einer Verzögerungsschaltung vorgesehen, über die das Halbleiterbauelement mit variablem steuerbarem Durchgangswiderstand so ansteuerbar ist, dass dessen Durchgangswiderstand mit einem jeweiligen Einschalten der Stromversorgung durch Reduzierung der Aufladungsgeschwindigkeit des Eingangskondensators ausgehend von einem relativ höheren Wert mit einer vorgegebenen oder vorgebbaren Zeitkonstante zunehmend kleiner wird.

Aufgrund dieser Ausbildung wird auf einfache und zuverlässige Weise eine weitere effektive Begrenzung der Aufladungsgeschwindigkeit des Eingangskondensators und damit des Einschaltstroms erreicht.

Bevorzugt umfasst die Einschaltstrombegrenzungseinrichtung eine Transistorschaltung mit wenigstens einem als Halbleiterbauelement mit variablem Durchschaltwiderstand dienenden, über die Verzögerungsschaltung ansteuerbaren Transistor.

Dabei ist insbesondere von Vorteil, wenn der Transistor der Transistorschaltung einen über seine Kollektor-Emitter- oder Source-Drain-Strecke mit dem Eingangskondensator in Reihe schaltbaren bipolaren bzw. Feldeffekttransistor umfasst, der zur Herabsetzung der Aufladungsgeschwindigkeit des Eingangskondensators und entsprechend weiteren Reduktion des Einschaltstroms über die Verzögerungsschaltung ansteuerbar ist.

Indem der Transistor über die Verzögerungsschaltung so ansteuerbar ist, dass dessen mit dem Eingangskondensator in Reihe geschaltete Kollektor-Emitter- bzw. Source-Drain-Strecke mit einer vorgegebenen oder vorgebbaren Zeitkonstante durchgeschaltet wird, um den Durchgangswiderstand ausgehend von einem relativ höheren Wert entsprechend langsam zu verringern, wird auch der Eingangskondensator langsamer aufgeladen, wodurch der Einschaltstrom entsprechend begrenzt wird.

Eine besonders einfache Schaltungsanordnung erhält man, wenn die Verzögerungsschaltung ein RC-Glied in Tiefpasskonfiguration umfasst.

Aufgrund der integrierenden Funktion eines solchen RC-Glieds in Tiefpasskonfiguration wird der Transistor entsprechend verzögert bzw. langsamer durchgeschaltet.

Bevorzugt umfasst die Verzögerungsschaltung einen Spannungsteiler mit dem RC-Glied in Tiefpasskonfiguration und einen ohmschen Widerstand. Dabei kann der ohmsche Widerstand insbesondere zum Kondensator des RC-Glieds parallel geschaltet und die Parallelschaltung aus dem ohmschen Widerstand und dem Kondensator des RC-Glieds parallel zur Basis-Emitter- bzw. Gate-Source-Strecke des Transistors geschaltet sein.

Die Verzögerungsschaltung bzw. der Spannungsteiler ist eingangsseitig bevorzugt mit der Stromversorgungseinrichtung verbindbar.

Der Transistor der Transistorschaltung umfasst zweckmäßigerweise einen Metall-Oxid-Halbleiter-Feldeffekttransistor (MOSFET). Dabei kann er insbesondere einen n-Kanal-MOSFET vom Anreicherungstyp umfassen.

Die Stromversorgungseinrichtung kann eine Wechselspannungsquelle und/oder eine Gleichspannungsquelle umfassen.

Der Eingangskondensator umfasst bevorzugt einen Entstörkondensator zur Herabsetzung elektromagnetischer Störungen.

In bestimmten Fällen kann der Eingangskondensator auch als Glättkondensator einem Transformator, insbesondere einem Transformator mit zugeordnetem Gleichrichter, nachgeschaltet sein.

Es sind insbesondere auch solche Ausführungen des erfindungsgemäßen Türöffners denkbar, bei denen der Eingangskondensator mit einem Schaltkontakt, insbesondere einem Relais, in Reihe geschaltet ist. Durch die erfindungsgemäße weitere Begrenzung des Einschaltstroms kann insbesondere einem Verkleben eines solchen mit dem Eingangskondensator in Reihe geschalteten Relais entgegengewirkt werden.

Zweckmäßigerweise ist die Einschaltstrombegrenzungseinrichtung in der Elektronik des Türöffners integriert.

Mit der erfindungsgemäßen Einschaltstrombegrenzung wird somit der Einschaltstrom des Türöffners weiter begrenzt. Es kann damit beispielsweise der Gefahr eines Verklebens eines mit dem Eingangskondensator als Schaltkontakt in Reihe geschalteten Relais entgegengewirkt werden. Die Einschaltstrombegrenzungseinrichtung kann in der Elektronik des Türöffners integriert sein. Zur Einschaltstrombegrenzung ist kein externes Bauteil mehr erforderlich. Es tritt auch kein Spannungsabfall über einen Widerstand mehr auf. Der Türöffner ist im Aufbau relativ einfach gehalten und damit entsprechend kostengünstig herstellbar. Die erfindungsgemäße Einschaltstrombegrenzung ist unabhängig von irgendeinem Mikrocontroller oder dergleichen realisiert. Sie ist sowohl bei einer Gleichstrom- als auch bei einer Wechselstromversorgung anwendbar. Von Vorteil ist insbesondere auch, dass keine Hitzeentwicklung auftritt.

Die Erfindung wird im Folgenden anhand eines Ausführungsbeispiels unter Bezugnahme auf die Zeichnung näher erläutert. In dieser zeigt die einzige Figur in schematischer Darstellung eine beispielhafte Ausführungsform eines erfindungsgemäßen Türöffners 10.

Danach umfasst der Türöffner 10 eine wenigstens einen Eingangskondensator 12 umfassende integrierte Elektronik 14, die durch eine Stromversorgungseinrichtung 16 über eine zur Begrenzung des Einschaltstroms mit dem Eingangskondensator 12 in Reihe schaltbare, insbesondere stromkompensierte Drossel 18 mit Strom versorgbar ist.

Zur weiteren Begrenzung des Einschaltstroms ist eine Einschaltstrombegrenzungseinrichtung 20 vorgesehen. Dabei umfasst diese Einschaltstrombegrenzungseinrichtung 20 ein mit dem Eingangskondensator 12 in Reihe schaltbares Halbleiterbauelement 22 mit variablem steuerbarem Durchgangswiderstand und eine Verzögerungsschaltung 24, über die das Halbleiterbauelement 22 mit variablem steuerbarem Durchgangswiderstand so ansteuerbar ist, dass dessen Durchgangswiderstand mit einem jeweiligen Einschalten der Stromversorgung zur Reduzierung der Aufladungsgeschwindigkeit des Eingangskondensators 12 ausgehend von einem relativ höheren Wert mit einer vorgegebenen oder vorgebbaren Zeitkonstante zunehmend kleiner wird.

Im vorliegenden Fall umfasst die Einschaltstrombegrenzungseinrichtung 20 beispielsweise eine Transistorschaltung 26 mit wenigstens einem als Halbleiterbauelement 22 mit variablem Durchschaltwiderstand dienenden, über die Verzögerungsschaltung 24 ansteuerbaren Transistor 28.

Der Transistor 28 der Transistorschaltung 26 umfasst einen über seine Kollektor-Emitter- oder Source-Drain-Strecke mit dem Eingangskondensator 12 in Reihe schaltbaren bipolaren bzw. Feldeffekttransistor, der zur Herabsetzung der Aufladungsgeschwindigkeit des Eingangskondensators 12 und entsprechend weiteren Reduktion des Einschaltstroms über die Verzögerungsschaltung 24 ansteuerbar ist.

Der Transistor 28 der Transistorschaltung 26 umfasst beispielsweise einen Metall-Oxid-Halbleiter-Feldeffekttransistor (MOSFET). Im vorliegenden Fall handelt es sich bei diesem MOSFET-Transistor 28 beispielsweise um einen n-Kanal-MOSFET vom Anreicherungstyp.

Die Verzögerungsschaltung 24 umfasst einen Spannungsteiler 30 mit einem RC-Glied 26 in Tiefpasskonfiguration und einem ohmschen Widerstand 34.

Dabei ist der ohmsche Widerstand 34 zum Kondensator C des RC-Glieds 32 parallelgeschaltet und der Widerstand R des RC-Glieds 32 mit der Parallelschaltung aus dem Kondensator C und dem ohmschen Widerstand 34 in Reihe geschaltet.

Die Verzögerungsschaltung 24 bzw. der Spannungsteiler 30 ist eingangsseitig mit der Stromversorgungseinrichtung 16 verbunden. Ausgangsseitig bzw. mit seiner den Kondensator C des RC-Glieds 32 sowie den ohmschen Widerstand 34 enthaltenden Parallelschaltung ist er parallel zur Gate-Source-Strecke des im vorliegenden Fall beispielsweise als Metall-Oxid-Halbleiter-Feldeffekttransistor (MOSFET) vorgesehenen Transistors 28 geschaltet.

Die Stromversorgungseinrichtung 16 umfasst eine Wechselspannungsquelle 16' und/oder eine Gleichspannungsquelle 16".

Mit einem jeweiligen Einschalten der Stromversorgungseinrichtung 16 steigt die an den Transistor 28 angelegte Steuerspannung bzw. dessen Gate-Source-Spannung infolge des das integrierende RC-Glied 26 in Tiefpasskonfiguration umfassenden Spannungsteilers 30 der Verzögerungsschaltung 24 entsprechend der Zeitkonstante des RC-Glieds 26 verlangsamt an, womit der Transistor 28 bzw. dessen Drain-Source-Strecke entsprechend langsamer durchgeschaltet wird. Mit dem langsameren Anstieg des Stromflusses durch den Transistor bzw. dessen Drain-Source-Strecke wird die Aufladung des Eingangskondensators 12 entsprechend verlangsamt.

Der Eingangskondensator 12 kann einen Entstörkondensator zur Herabsetzung elektromagnetischer Störungen umfassen. Es sind auch solche Ausführungen denkbar, bei denen der Eingangskondensator 12 als Glättungskondensator einem Transformator, insbesondere einem Transformator mit zugeordnetem Gleichrichter, nachgeschaltet ist.

Der Eingangskondensator 12 kann beispielsweise auch mit einem Schaltkontakt, insbesondere einem Relais, in Reihe geschaltet sein. In diesem Fall wird durch die erfindungsgemäße, eine weitere Einschaltstrombegrenzung mit sich bringende Einschaltstrombegrenzungseinrichtung 20 der Gefahr eines Verklebens des Relais durch einen zu hohen Einschaltstrom entgegengewirkt.

Die Einschaltstrombegrenzungseinrichtung 20 kann in der Elektronik 14 des Türöffners 10 integriert sein.

Die stromkompensierte Drossel 18 bewirkt bereits eine gewisse Begrenzung des Einschaltstroms. Durch die erfindungsgemäße Einschaltstrombegrenzungseinrichtung 20 wird der Einschaltstrom weiter begrenzt, indem die Aufladungsgeschwindigkeit des Eingangskondensators 12 zusätzlich verlangsamt wird. Aufgrund des das integrierende RC-Glied 32 umfassenden Spannungsteilers 30 steigt bei einem jeweiligen Einschalten oder Betätigen des Türöffners 10 die Gate-Source-Spannung am Transistor 22 langsam an, so dass der Transistor 22 langsam durchgeschaltet und dessen Durchgangswiderstand damit ausgehend von einem relativ höheren Wert langsam reduziert wird. Damit wird der Eingangskondensator 12 langsamer aufgeladen, wodurch der Einschaltstrom weiter begrenzt wird.

### Bezugszeichenliste

- 10: Türöffner
- 12: Eingangskondensator
- 14: Elektronik
- 16: Stromversorgungseinrichtung
- 16': Wechselspannungsquelle
- 16": Gleichspannungsquelle
- 18: Drossel
- 20: Einschaltstrombegrenzungseinrichtung
- 22: Halbleiterbauelement
- 24: Verzögerungsschaltung
- 26: Transistorschaltung
- 28: Transistor
- 30: Spannungsteiler
- 32: RC-Glied
- 34: ohmscher Widerstand
- C: Kondensator des RC-Glieds
- R: Widerstand des RC-Glieds

## Patentansprüche

1. Türöffner (10) zum Entsperren einer Türfalle, mit einer wenigstens einen Eingangskondensator (12) umfassenden integrierten Elektronik (14), die durch eine Stromversorgungseinrichtung (16) über eine zur Begrenzung des Einschaltstroms mit dem Eingangskondensator (12) in Reihe schaltbare, insbesondere stromkompensierte Drossel (18) mit Strom versorgbar ist, wobei zur weiteren Begrenzung des Einschaltstroms eine Einschaltstrombegrenzungseinrichtung (20) mit einem mit dem Eingangskondensator (12) in Reihe schaltbaren Halbleiterbauelement (22) mit variablem steuerbarem Durchgangswiederstand und einer Verzögerungsschaltung (24) vorgesehen ist, über die das Halbleiterbauelement (22) mit variablem steuerbarem Durchgangswiderstand so ansteuerbar ist, dass dessen Durchgangswiderstand mit einem jeweiligen Einschalten der Stromversorgung zur Reduzierung der Aufladungsgeschwindigkeit des Eingangskondensators (12) ausgehend von einem relativ höheren Wert mit einer vorgegebenen oder vorgebaren Zeitkonstante zunehmend kleiner wird.

2. Türöffner nach Anspruch 1,
**dadurch gekennzeichnet,**
**dass** die Einschaltstrombegrenzungseinrichtung (20) eine Transistorschaltung (26) mit wenigstens einem als Halbleiterbauelement (22) mit variablem Durchschaltwiderstand dienenden, über die Verzögerungsschaltung (24) ansteuerbaren Transistor (28) umfasst.

3. Türöffner nach Anspruch 2,
**dadurch gekennzeichnet,**
**dass** der Transistor (28) der Transistorschaltung (26) einen über seine Kollektor-Emitter- oder Source-Drain-Strecke mit dem Eingangskondensator (12) in Reihe schaltbaren bipolaren bzw. Feldeffekttransistor umfasst, der zur Herabsetzung der Aufladungsgeschwindigkeit des Eingangskondensators (12) und entsprechend weiteren Reduktion des Einschaltstroms über die Verzögerungsschaltung (24) ansteuerbar.

4. Türöffner nach einem der vorstehenden Ansprüche,
**dadurch gekennzeichnet,**
**dass** die Verzögerungsschaltung (24) ein RC-Glied (26) in Tiefpasskonfiguration umfasst.

5. Türöffner nach Anspruch 4,
**dadurch gekennzeichnet,**
**dass** die Verzögerungsschaltung (24) einen Spannungsteiler (30) mit dem RC-Glied (26) in Tiefpasskonfiguration und einem ohmschen Widerstand (34) umfasst.

6. Türöffner nach Anspruch 4 oder 5,
**dadurch gekennzeichnet,**
**dass** die Verzögerungsschaltung (24) bzw. der Spannungsteiler (30) eingangsseitig mit der Stromversorgungseinrichtung (16) verbindbar ist.

7. Türöffner nach einem der vorstehenden Ansprüche,
**dadurch gekennzeichnet,**
**dass** der Transistor (28) der Transistorschaltung (26) einen Metall-Oxid-Halbleiter-Feldeffekttransistor (MOSFET) umfasst.

8. Türöffner nach Anspruch 7,
**dadurch gekennzeichnet,**
**dass** der Transistor (28) der Transistorschaltung (26) einen n-Kanal-MOSFET vom Anreicherungstyp umfasst.

9. Türöffner nach einem der vorstehenden Ansprüche,
**dadurch gekennzeichnet,**
**dass** die Stromversorgungseinrichtung (16) eine Wechselspannungsquelle (16') und/oder eine Gleichspannungsquelle (16") umfasst.

10. Türöffner nach einem der vorstehenden Ansprüche,
**dadurch gekennzeichnet,**
**dass** der Eingangskondensator (12) einen Entstörkondensator zur Herabsetzung elektromagnetischer Störungen umfasst.

11. Türöffner nach einem der vorstehenden Ansprüche,
**dadurch gekennzeichnet,**
**dass** der Eingangskondensator (12) als Glättungskondensator einem Transformator, insbesondere einem Transformator mit zugeordnetem Gleichrichter, nachgeschaltet ist.

12. Türöffner nach einem der vorstehenden Ansprüche,
**dadurch gekennzeichnet,**
**dass** der Eingangskondensator (12) mit einem Schaltkontakt, insbesondere einem Relais, in Reihe geschaltet ist.

13. Türöffner nach einem der vorstehenden Ansprüche,
**dadurch gekennzeichnet,**
**dass** die Einschaltstrombegrenzungseinrichtung (20) in der Elektronik (14) integriert ist.
